# EUROPEAN PATENT SPECIFICATION

(11) **EP 4 525 047 B1**
(45) Date of publication and mention of the grant of the patent: **18.02.2026**
(21) Application number: 23197929.5
(22) Date of filing: 18.09.2023
(51) Int. Cl.: H10D 10/01, H10D 10/80, H10D 62/17

(54) **METHOD OF MAKING A BIPOLAR TRANSISTOR**
VERFAHREN ZUR HERSTELLUNG EINES BIPOLARTRANSISTORS
PROCÉDÉ DE FABRICATION D'UN TRANSISTOR BIPOLAIRE

(43) Date of publication of application: 19.03.2025
(73) Proprietor: NXP B.V., 5656 AG Eindhoven (NL)
(72) Inventor: JOHN, Jay, 5656AG Eindhoven (NL); KIRCHGESSNER, James, 5656AG Eindhoven (NL); DONKERS, Johannes, 5656AG Eindhoven (NL); RADIC, Ljubo, 5656AG Eindhoven (NL); SEBEL, Patrick, 5656AG Eindhoven (NL)
(74) Representative: Miles, John Richard

(56) References cited:
- WO-A1-2008/001249
- US-A1- 2005 151 225
- US-B1- 6 559 020

## Description

### FIELD

This disclosure relates to a method of making a bipolar transistor.

### BACKGROUND

High frequency, high performance SiGe heterojunction bipolar transistors require low base access resistance in order to achieve high maximum oscillation frequencies (f_{MAX}). This figure of merit is extremely important for the newer 5G/6G product space.

One of the largest components of the base resistance in these structures is the link resistance between the base poly electrode and the internal base connection of the transistor. Typically, HBT structures use polysilicon for the extrinsic base region. One process flow uses a hydrogen ambient annealing step to "seal" the gap between the extrinsic base and the emitter silicon cap, by relying on the enhanced mobility of silicon in hydrogen to form this final electrical connection from the extrinsic to intrinsic base. However, there are several limitations and challenges with this sealing process.

The sealed region relies on a source of silicon from the extrinsic base and/or emitter silicon cap. A large gap between extrinsic base poly and emitter silicon cap is undesirable and can lead to deformation of the base poly. A smaller gap may therefore be preferred. However, the gap between the extrinsic base poly and emitter silicon cap is hard to scale vertically. The gap may be defined by an oxide layer, which must be thick enough for the emitter window etch to stop in. Moreover, the final sealed region is not doped in-situ (because the intrinsic base is exposed), making it difficult to optimize the link resistance. US 2005/0151225 A1 describes a bipolar transistor structure with self-aligned raised extrinsic base and methods. According to US 2005/0151225 A1, a landing pad made of an insulating material is first formed on an intrinsic base layer. An extrinsic base layer is then applied on top of the landing pad. Next, an opening is created in the extrinsic base layer to expose the landing pad. The exposed portion of the landing pad is removed, along with a portion of the landing pad beneath the extrinsic base layer, thereby forming a cavity. Finally, a base link is formed within the cavity. US 6559020 B1 describes a bipolar device with a silicon germanium base region. WO 2008/001249 A1 describes a method of manufacturing a bipolar transistor and bipolar transistor obtained therewith.

### SUMMARY

Aspects of the disclosure are set out in the accompanying independent claim and dependent claims.

According to an aspect of this disclosure, there is provided a method of making a bipolar transistor, as defined in claim 1, the method comprising:
providing a semiconductor substrate comprising:
   a major surface;
   one or more layers located beneath the major surface for forming an intrinsic base of the bipolar transistor; and
   a collector located beneath the one or more layers;
depositing a first oxide layer on the major surface;
depositing a second oxide layer on the first oxide layer;
depositing an extrinsic base layer on the second oxide layer;
forming an emitter window through the extrinsic base layer;
removing at least a part of the second oxide layer to form a first cavity between the first oxide layer and the extrinsic base layer;
forming an initial part of a base link region in the first cavity;
removing at least a part of the first oxide layer to form a second cavity between the major surface and the initial part of the base link region;
filling the second cavity to form a completed base link region from the initial part of the base link region and the filled cavity; and
forming an emitter in the emitter window. The second oxide layer has a faster etch rate than the first oxide layer. This allows preferential removal of the second oxide layer relative to the first oxide layer during formation of the first cavity.

The method may comprise, prior to depositing the extrinsic base layer, patterning the first and second oxide layers to form an island comprising a remaining part of the first oxide layer and a remaining part of the second oxide layer.

Depositing the extrinsic base layer may comprise depositing the extrinsic base layer on the island and parts of the major surface that surround a periphery of the island.

Forming the emitter window may expose a central region of the island.

Removing at least a part of the second oxide layer may comprise removing the remaining part of the second oxide layer. Removing at least a part of the first oxide layer may comprise removing the remaining part of the first oxide layer.

The faster etch rate of the second oxide layer may cause the remaining part of the second oxide layer to have a smaller footprint than the remaining part of the first oxide layer.

Forming the initial part of a base link region in the first cavity may comprise a Si and/or SiGe growth step.

The method may further comprise forming an emitter spacer in the emitter window after forming the completed base link region and prior to forming the emitter in the emitter window.

The method may comprise using a hydrogen sealing process to fill the second cavity.

The method may comprise using a selective epitaxial growth step to fill the second cavity.

The first oxide layer may be thinner than the second oxide layer.

### BRIEF DESCRIPTION OF THE DRAWINGS

Embodiments of the present disclosure will be described hereinafter, by way of example only, with reference to the accompanying drawings in which like reference signs relate to like elements and in which:
Figures 1 to 10 show a method of making a bipolar transistor in accordance with an embodiment of this disclosure; and
Figures 11 to 17 show a method of making a bipolar transistor in accordance with another embodiment of this disclosure.

### DETAILED DESCRIPTION

Embodiments of the present disclosure are described in the following with reference to the accompanying drawings.

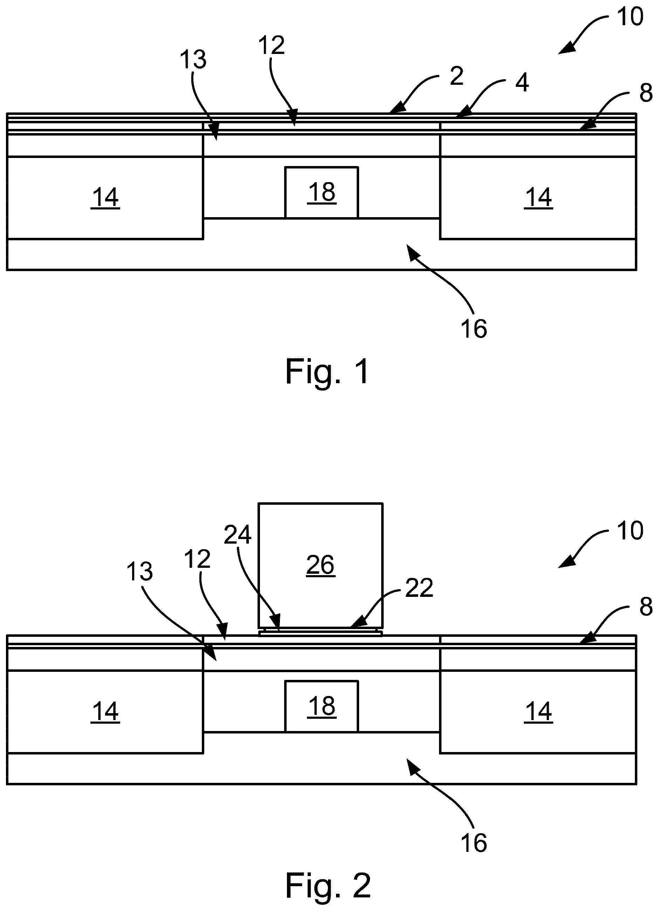

Figures 1 to 10 show a method of making a bipolar transistor 10 in accordance with an embodiment of this disclosure. In a first step, shown in Figure 1, there is provided a semiconductor substrate. The substrate may be a silicon substrate. The substrate has a major surface.

The substrate also includes one or more layers located beneath the major surface for forming an intrinsic base of the bipolar transistor 10. In the present embodiment, the one or more layers include a Si layer 12, SiGe layer 8 located beneath the Si layer 12 and a further Si layer 13 located beneath the SiGe layer 8. These three layers form a base stack for forming the intrinsic base of the bipolar transistor 10. It will be appreciated that the exact number and/or composition of the one or more layers described above may vary in other embodiments, as long as they fulfil the purpose of allowing the intrinsic base of the bipolar transistor to be formed.

The substrate also includes a collector located beneath the aforementioned one or more layers for forming the intrinsic base. In the present embodiment, the collector includes a doped (e.g., N+) collector region (e.g., in the form of a buried layer) and a locally doped collector region 18 (SIC). It will be appreciated that the collector structure shown in Figure 1 is just an example and that other collector arrangements may also be used in accordance with embodiments of this disclosure.

In some embodiments, the substrate may also include isolation regions 14 (e.g., Shallow Trench Isolation (STI) and/or Deep Trench Isolation (DTI)) for isolating the bipolar transistor from neighbouring regions of the substrate. These isolation regions may extend down into the substrate from the major surface of the substrate.

In a next step, a first oxide layer 4 is deposited on the major surface of the substrate. The first oxide layer 4 may, for instance, be formed using a High Temperature Oxide (HTO) process. The first oxide layer 4 may have a thickness of around 100 Angstroms, although this thickness may vary according to the overall dimensions and layout of the bipolar transistor.

In a next step, a second oxide layer 2 is deposited on the first oxide layer 4. The second oxide layer 2 may, for instance, be formed using a TEOS process. The second oxide layer 2 may, in some embodiments, be thicker than the first oxide layer (e.g., around 300 Angstroms), although again it will be appreciated that this thickness may vary according to the overall dimensions and layout of the bipolar transistor.

According to the invention, the composition of the first 4 and second 2 oxide layers, and the subsequently used etchants, is chosen such that the second oxide layer has a higher etching rate than the first oxide layer 4 (for instance, the etching ratio may be around 6:1 in some embodiments).

In a next step, shown in Figure 2, masking and etching steps may then be used to pattern the first 4 and second 2 oxide layers. A patterned layer of photo resist 26 may be used to perform this patterning of the oxide layers 2, 4. Any suitable etching process may be used (e.g., an oxide et etch or Reactive Ion Etch (RIE) + wet etch).

As noted above, the etching rate of the second oxide layer 2 is higher than the etching rate of the first oxide layer 4. This may result in the structure shown in Figure 2, in which the lateral extent of the remaining part 22 of the second oxide 2 layer is smaller than the lateral extent of the remaining part 24 of the first oxide layer 4. Note that isotropic etching (e.g., using a wet etch chemistry) may, in any event, lead to some inward, lateral etching of the both oxide layers 2, 4, so that the edges of the patterned photoresist overhang both the first 4 and second 2 oxide layers. Accordingly, the remaining parts 22, 24 of the oxide layers 2, 4 form an island (e.g., in the form of a stepped mesa structure), with the remaining part of the second oxide layer 22 having a slightly smaller footprint than the remaining part of the first oxide layer 24. Note also that the layout of the patterned photoresist 26 may be chosen such that the remaining parts 24, 22 of the first 4 and second 2 oxide layers are located directly above the collector (e.g., centered on the locally doped collector region 18). After the first 4 and second 2 oxide layers have been patterned as described above, the photoresist 26 may be removed.

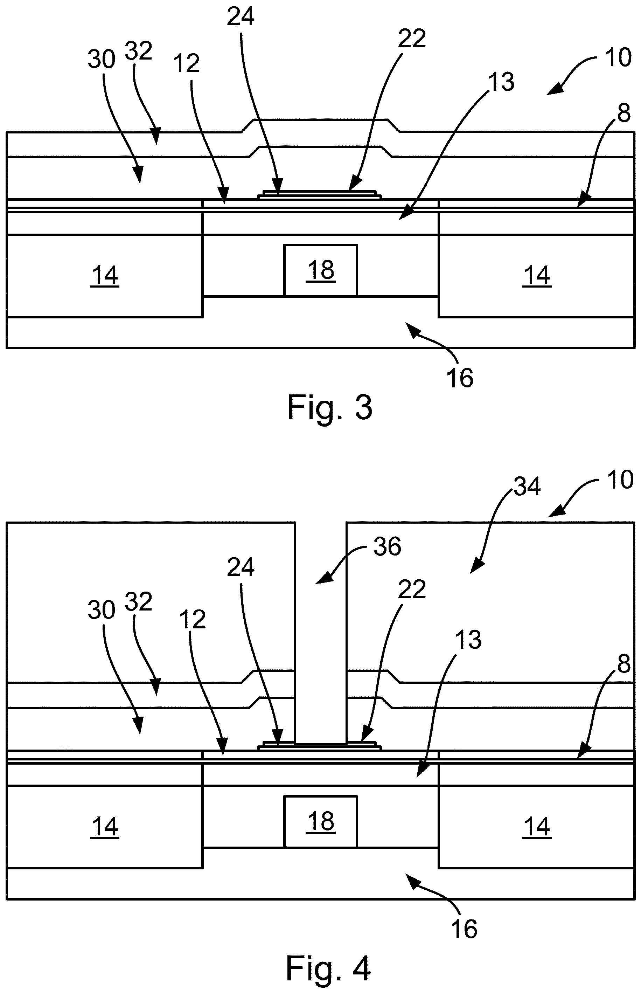

In a next step, shown in Figure 3, an extrinsic base layer 30 is deposited on the second oxide layer 2. In particular, the extrinsic base layer 30 may be deposited to cover the remaining part of the second oxide layer 22. In the present embodiment, the extrinsic base layer 30 also covers the regions of the major surface of the substrate located around the periphery of the island formed by the remaining parts 22, 24 of the oxide layers. Any suitable conductive material (e.g., doped polysilicon or silicon germanium) may be used for the extrinsic base layer 30. In the present embodiment, polysilicon is used. The thickness of the extrinsic base layer 30 may be around 1100 Angstroms, but again it will be appreciated that this thickness may vary according to the overall dimensions and layout of the bipolar transistor.

As shown in Figure 3, a base nitride layer 32 may, in some embodiments, then be deposited on the extrinsic base layer 30. The base nitride layer 32 may be thinner than the extrinsic base layer 30 (e.g., around 800 Angstroms), but once again it will be appreciated that this thickness may vary according to the overall dimensions and layout of the bipolar transistor.

Turning now to Figure 4, in a next step, an emitter window 36 is formed in the extrinsic base layer 30 (and also the base nitride layer 32). The emitter window 36 may be formed using a mask formed by a patterned photoresist layer 34. Note that the formation of the emitter window 36 exposes the remaining part of the second oxide layer 22 and that the emitter window 36 may be located directly above the collector (e.g., centered on the locally doped collector region 18). Note also that the lateral width of the emitter window 36 is narrower than that of the remaining part of the second oxide layer 22, so that the peripheral region of the remaining part of the second oxide layer 22 remain covered by the extrinsic base layer 30.

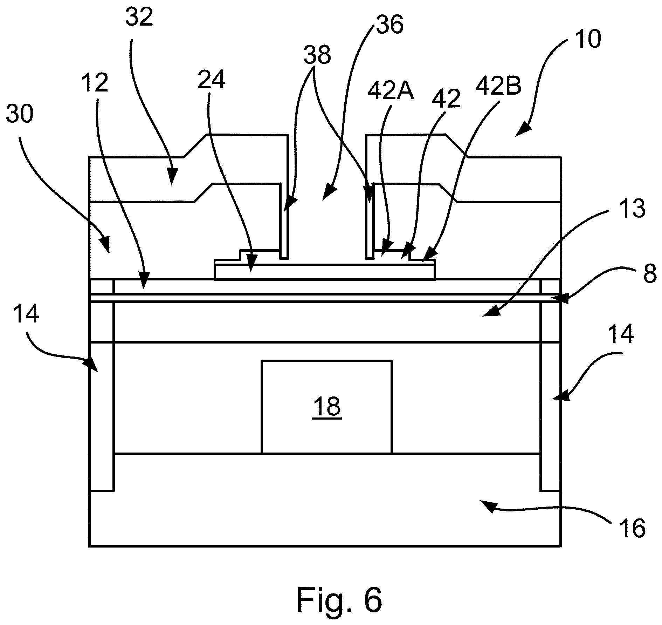

Any suitable etching process may be used to form the emitter window 36 (e.g., RIE). In this embodiment, the remaining part of the second oxide layer 22 acts as an etch stop at the bottom of the emitter window 36, thereby protecting the underlying surface of the semiconductor substrate and, in particular, the one or more layers forming the intrinsic base of the bipolar transistor. Nevertheless, some of the exposed material of the remaining part of the second oxide layer 22 may be etched away during this step, leading to a thinning of the portion of the remaining part of the second oxide layer 22 that is located directly beneath the emitter window 36 (this thinning is visible in Figure 4 and more clearly visible in, for example, Figure 6).

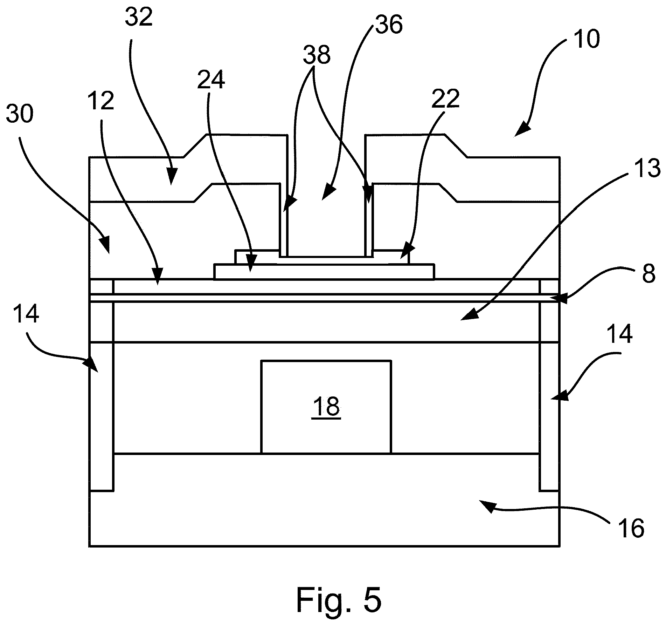

In a next step, shown in Figure 5, the photoresist 34 may be removed. At this time, a sidewall spacer 38 may also be formed on the inner sidewall of the emitter window 36. The sidewall spacer 38 may comprise a nitride (e.g., SiN). The sidewall spacer 38 may be formed by depositing a layer of the nitride material and then performing a further etching process (e.g., RIE) to remove the nitride material from the bottom of the emitter window 36 while leaving a portion the nitride material on the sidewall of the emitter window. This etching step may further thin the remaining part of the second oxide layer 22, although again the remaining part of the second oxide layer 22 can act as an etch stop to protect the underlying surface of the semiconductor substrate. A typical thickness of the exposed portion of the remaining part of the second oxide layer 22 at the end of the process step shown in Figure 5 may still be greater than that of the remaining part of the first oxide layer 24 (e.g., in the case of the example initial layer thicknesses mentioned above, the thinning of the remaining part of the second oxide layer 22 may result in an exposed portion thereof having a thickness of around 200 Angrstroms, with the remaining part of the first oxide layer 24 having a thickness of around 100 Angstroms).

In a next step, shown in Figure 6, at least a part of the remaining part of the second oxide layer 22 is removed, e.g., using a further etch. In the example shown in Figure 5, all of the remaining part of the second oxide layer 22 is removed.

As shown in Figure 6, this etching process may also, in some embodiments, remove some of the underlying remaining part of the first oxide layer 24. For instance, in the case of the example initial layer thicknesses mentioned above, the thinning of the remaining part of the first oxide layer 24 during this step may result in an exposed portion thereof having a thickness of around 30 Angrstroms, with 70 Angstroms having been removed. During this step, the remaining part of the first oxide layer 24 acts as an etch stop, again to protect the underlying surface of the semiconductor substrate. Note that the above-discussed differing etching rates of the first 4 and second 2 oxide layers allows preferential etching of the remaining part of the second oxide layer 22 over the remaining part of the first oxide layer 24 during this step.

As also shown in Figure 6, the etching process of this step results in the formation of a first cavity 42. The first cavity 42 is located between the remaining part of the first oxide layer 24 and the extrinsic base layer 30. Accordingly, the location of the first cavity 42 corresponds to the location of the portion of the (now removed) remaining part of the second oxide layer 22 that was located in between the extrinsic base layer 30 and the remaining part of the first oxide layer 24. Due to the thinning of the remaining part of the first oxide layer 22 during the present etching step, the cavity 42 may also correspond in location to any portions of the remaining part of the first oxide layer 22 that were removed from in between the extrinsic base layer 30 and the major surface of the semiconductor substrate.

Note that in some embodiments, as shown in Figure 6, the cavity 42 may thus have a stepped shaped comprising a peripheral shallower region 42B (due to some removal of the first oxide layer 24 under the extrinsic base layer 30) and a deeper region 42A adjacent the emitter window 36 (with the deeper region 42A corresponding to the location of the now removed remaining part of the second oxide layer 22).

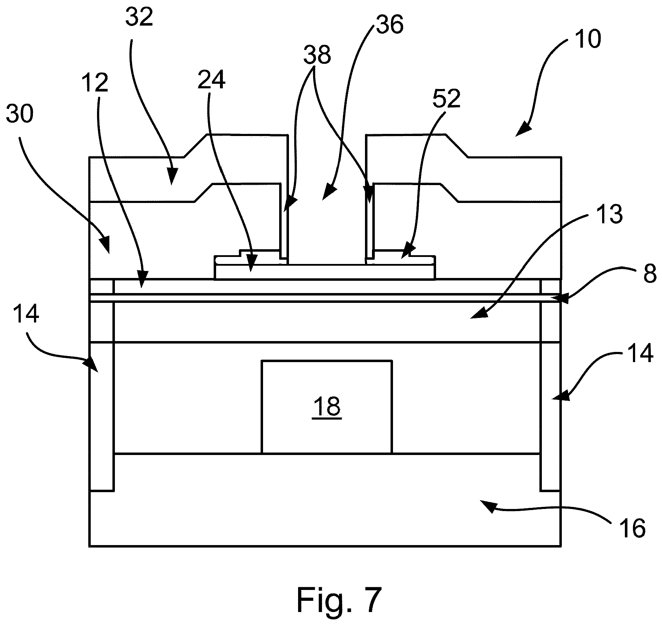

In a next step, shown in Figure 7, an initial part 52 of a base link region of the bipolar transistor is formed in the first cavity 42. The initial part 52 of a base link region may be grown epitaxially and may, for instance, comprise doped (e.g., p+ doped) Si and/or SiGe. Note that the initial part 52 of a base link region may substantially fill the first cavity 42 as is shown in Figure 7. Note that because the intrinsic base (layers 8, 12, and 14) is still covered by a portion of the first oxide layer 24, the initial part 52 of a base link region may be heavily doped to be as conductive as possible, without unintentionally doping the intrinsic base region.

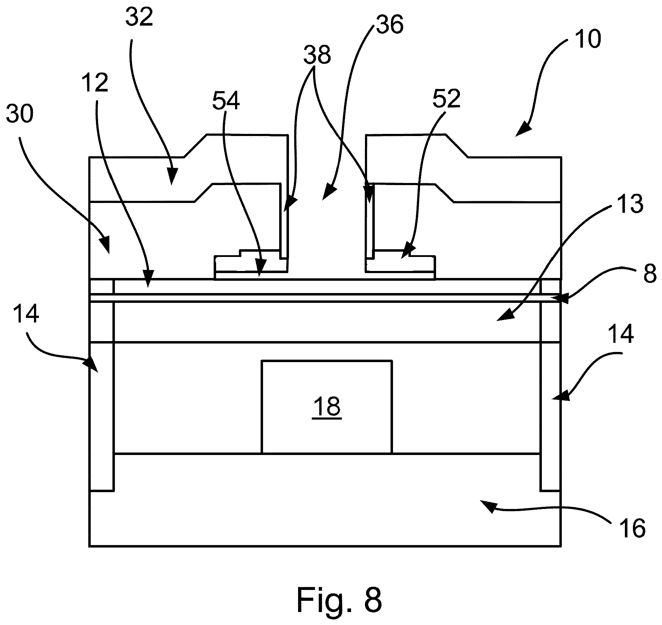

In a next step, shown in Figure 8, at least a part of the remaining part of the first oxide layer 24 is removed, e.g., using a further etch (such as a hydrofluoric acid (HF) wet etch). In the example shown in Figure 8, all of the remaining part of the first oxide layer 24 is removed. As can be seen in Figure 8, the removal of the remaining part of the first oxide layer 24 forms a second cavity 54. The second cavity is located between the major surface of the substrate and the initial part 52 of the base link region. Note that the second cavity 54 is generally shallower than the first cavity 42 because of the relative thinness of the remaining part of the first oxide layer 24.

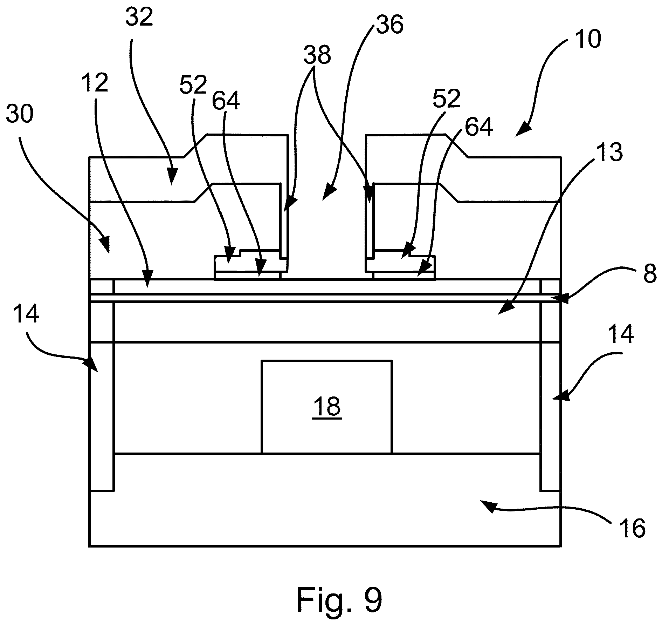

**In** a next step shown in Figure 9, the second cavity 54 is partially or completely filled (see integer 64 in Figure 9). The filling of the second cavity 54 may be achieved in a number of ways. **In** one embodiment, the second cavity is filled using a further epitaxial growth process similar to that described above in respect of the filling of the first cavity 42. **In** another embodiment, an annealing step (e.g., a hydrogen ambient annealing step) may be used, such that the initial part 52 of the base link region migrates down toward the major surface of the substrate. In either case, the filled part 64 may comprise the same material as the initial part 52 (doped (e.g., p+ doped) Si and/or SiGe).

The formation of the filled part 64 completes the formation of the base link region of the bipolar transistor. Note that together, the initial part 52 and the filled part 64 form a link between the extrinsic base layer 30 and the intrinsic base (e.g., the uppermost 12 of the one or more layers 12, 8, 13).

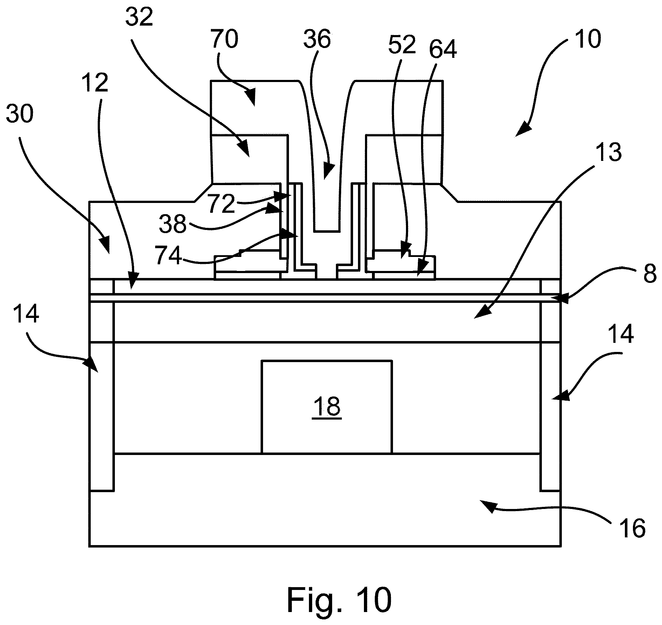

In a next step, as shown in Figure 10, having formed the base link region of the bipolar transistor, processing of the device may move on to formation of the emitter of the bipolar transistor. Various emitter arrangements are possible and compatible with embodiments of this disclosure: the arrangement shown in Figure 10 is illustrated merely by way of example.

In Figure 10, the emitter window sidewall spacer 38 may be added to by adding further spacer layers 72, 74. The further layers 72, 74 may comprise oxide and/or nitride. These further layers 72, 74 may be patterned as shown in Figure 10 to narrow the opening between the intrinsic base and the emitter window. The emitter 70 may then be deposited into the emitter window. The emitter 70 may include a monocrystalline part, in contact with the intrinsic base. The emitter 70 may also include an amorphous part located on top of the monocrystalline part. This amorphous part may extend out of the emitter window as shown Figure 10.

The extrinsic base layer 30, the base nitride layer 32 and the emitter 70 may then be patterned to remove any unwanted material. The device 10 then may be finished by silicidation and metallization steps, which may be conventional and which, for the purposes of brevity, are not described here in detail.

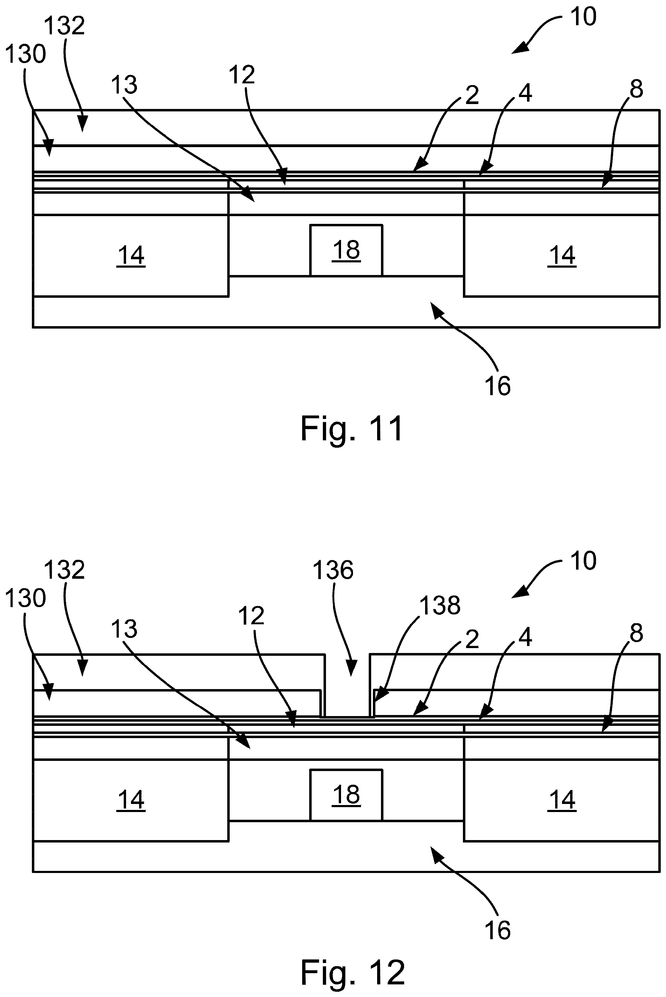

Figures 11 to 17 show a method of making a bipolar transistor 10 in accordance with another embodiment of this disclosure. Some aspects of this second embodiment are similar to the methodology described above in respect of Figure 1 to 10. Accordingly, only differences between the embodiment of Figures 1 to 10 and the embodiment of Figures 11 to 17 will be described below in detail.

In a first step, shown in Figure 11, there is provided a semiconductor substrate. The substrate may be substantially as already described above in relation to Figure 1. Unlike the embodiment of Figures 1 to 10, the first 4 and second 2 oxide layers are not patterned prior to the deposition of the extrinsic base layer 130 or the base nitride later 132. Accordingly, the first 4 and second 2 oxide layers remain in the form of blanket films covering the major surface of the substrate. Nevertheless, as before, the extrinsic base layer 130 is deposited on the second oxide layer 2 and the base nitride later 132 is deposited on the extrinsic base layer 130. The composition and thicknesses of the extrinsic base layer 130 and the base nitride later 132 may be substantially as described above in relation to Figures 1 to 10.

In a next step, shown in Figure 12, an emitter window 136 is formed in the extrinsic base layer 130 (and also the base nitride layer 132). The emitter window 136 may be formed using the masking and etching steps of the kind described above in relation to Figure 4. A sidewall spacer 138 may then be formed, using the same process as that described above in relation to Figure 5.

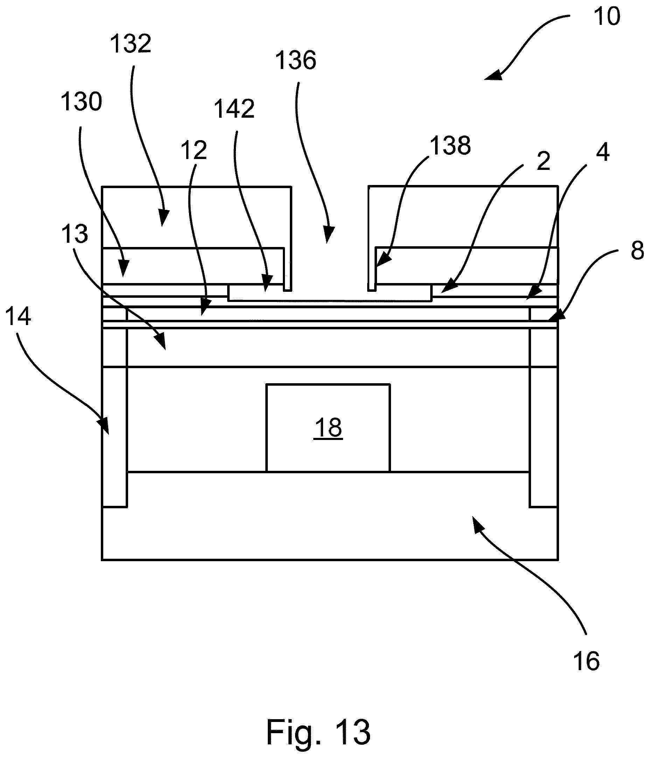

In a next step, shown in Figure 13, at least a part of the second oxide layer 2 is removed. The removal of at least a part of the second oxide layer 2 may involve an etching process of the kind described above in relation to Figure 6. Note that, as described in relation to Figure 6, the etching process used in Figure 13 can also lead to some thinning of the first oxide layer 4 (this is visible in Figure 13). Note that in this embodiment, the first cavity 142 does not have the stepped shape of the first cavity 42 shown in Figure 6.

In the absence of the patterning or the first 4 and second 2 oxide layers in this embodiment, the etching for removing at least part of the second oxide layer 2 in this embodiment may be timed such that a desired amount of under etching beneath the extrinsic base layer 130 takes place, for producing an appropriately sized first cavity 142. A potential advantage of the embodiment of Figures 1 to 10 is therefore that closer control of the lateral extent of the first cavity 42 in Figure 6 may be achieved (similar considerations apply to the formation of the second cavity in Figure 8).

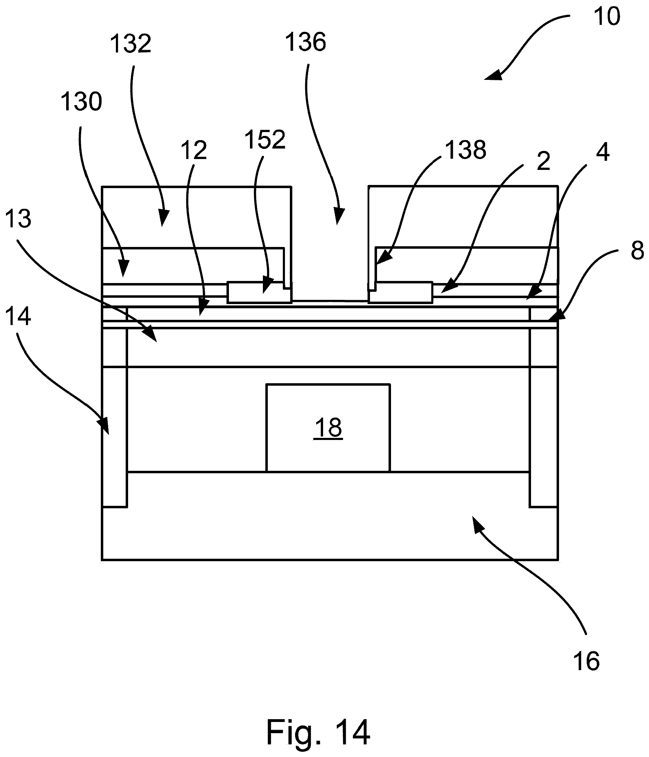

In a next step, shown in Figure 14, an initial part 152 of a base link region of the bipolar transistor is formed in the first cavity 142. The process for forming the initial part 152 of the base link region may be substantially as described above in relation to Figure 7.

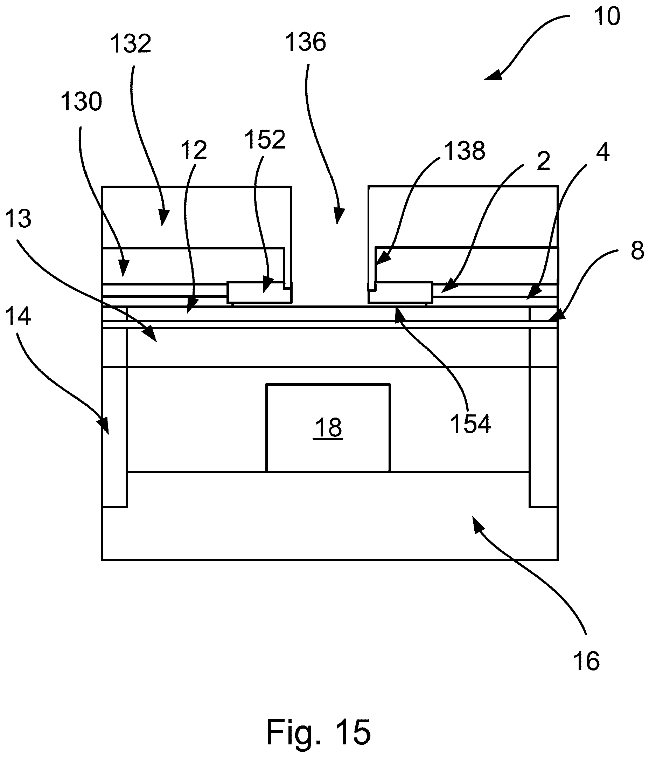

In a next step, shown in Figure 15, at least a part of the first oxide layer 4 is removed. The removal of at least a part of the first oxide layer 4 may involve an etching process of the kind described above in relation to Figure 8.

In the absence of the patterning or the first 4 and second 2 oxide layers in this embodiment, the etching for removing at least part of the first oxide layer 4 in this embodiment may be timed such that a desired amount of under etching beneath the second oxide layer 2 takes place, for producing an appropriately sized second cavity 154. Again, a potential advantage of the embodiment of Figures 1 to 10 is therefore that closer control of the lateral extent of the second cavity 54 in Figure 8 may be achieved.

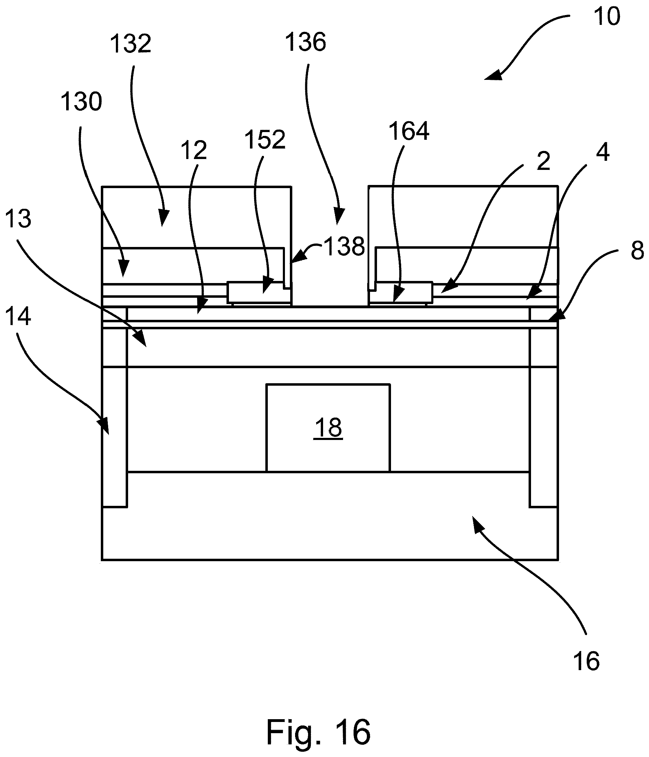

In a next step shown in Figure 16, the second cavity 154 is partially or completely filled (see integer 164 in Figure 16). The filling of the second cavity 154 may be achieved in any of the ways described above in relation to Figure 9. The formation of the filled part 164 completes the formation of the base link region of the bipolar transistor. Note that together, the initial part 152 and the filled part 164 form a link between the extrinsic base layer 130 and the intrinsic base (e.g., the uppermost 12 of the one or more layers 12, 8, 13).

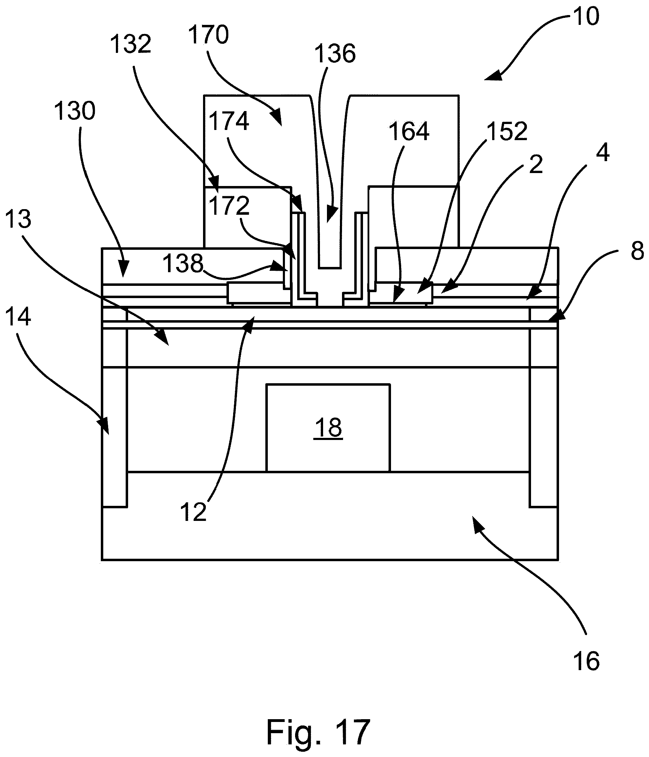

In a next step, shown in Figure 17, processing of the kind already described above in respect of Figure 10 may be performed, so as to form the further spacer layers 172, 174 and the emitter 170. As described above, further processing may include patterning of the extrinsic base layer 130, the base nitride layer 132 and the emitter 170 to remove any unwanted material. The device 10 then may be finished by silicidation and metallization steps, which may be conventional and which, again for the purposes of brevity, are not described here in detail.

In the absence of the patterning or the first 4 and second 2 oxide layers in this embodiment, a portion of the first 4 and second 2 oxide layers remain in place in the finished transistor. A potential advantage of this approach is that the collector-base junction capacitance of the bipolar transistor may be reduced, owing to the fact that the extrinsic base layer is additionally separated from the collector by remaining portions of the first 4 and second 2 oxide layers.

Embodiments of this disclosure can provide a base link region which has a low resistance compared to known devices, while the use of the first 4 and second oxide layers 2 (patterned as per the embodiment of Figures 1 to 10, or not patterned as per the embodiment of Figures 11 to 17) can protect the underlying intrinsic base of the bipolar transistor from the etching steps that are used to form the first and second cavities (42, 142, 54, 154) within which the base link region is to be formed.

When a hydrogen sealing process is used to produce the filled parts 64, 164, the fact that a two stage etching process has been used (in which the first stage removes the second oxide layer 2 and produces the initial part 52, 152 of a base link region of the bipolar transistor, and in which the second stage removes the first oxide layer 4 to form the second cavity 54, 154) means that the amount of sealing that is required to produce the filled parts 64, 164 is reduced compared to processes in which the entire cavity (i.e. both the first 42, 142 and second 54, 154 cavities) is sealed using a hydrogen sealing process. This approach can lead to better sealing of the overall cavity. Moreover, the presence of the initial part 52, 152 (which can be doped to be conductive) can lead to a reduction of the base link resistance as described above, compared to conventional processes in which a hydrogen sealing process is used to seal the entire cavity. Similarly, when epitaxy is used to form the filled parts 64, 164, the base link resistance may be lower than that achieved by conventional processes in which a hydrogen sealing process is used to seal the entire cavity.

There may be provided a bipolar transistor manufactured according to the methods described above. Bipolar transistors manufactured according to the methods described above are not claimed, but they are useful for understanding the present invention; said bipolar transistors may find particular use in, for example:
- radar applications - automotive (e.g., Advanced Driver Assistance Systems (ADAS)), industrial sensors;
- high speed communications - 5G/6G, satellite communications;
- high speed interfaces (e.g., Apple Lightning, Thunderbolt, USB 3, etc.); and/or
- mmWave applications -e.g., medical and/or security imaging applications

Accordingly, there has been described a bipolar transistor and a method of making a bipolar transistor.

Although particular embodiments of the disclosure have been described, it will be appreciated that many modifications/additions and/or substitutions may be made within the scope of the claims.

## Claims

1. A method of making a bipolar transistor (10), the method comprising:
providing a semiconductor substrate (16) comprising:
a major surface;
one or more layers (8, 12, 14) located beneath the major surface for forming an intrinsic base of the bipolar transistor; and
a collector (18) located beneath the one or more layers;
depositing a first oxide layer (4, 24) on the major surface;
depositing a second oxide layer (2, 22) on the first oxide layer (4);
depositing an extrinsic base layer (30) on the second oxide layer (22);
forming an emitter window (36) through the extrinsic base layer (30);
removing at least a part of the second oxide layer (22) to form a first cavity (42) between the first oxide layer (24) and the extrinsic base layer (30);
forming an initial part (52) of a base link region in the first cavity (42);
removing at least a part of the first oxide layer (24) to form a second cavity (54) between the major surface and the initial part (52) of the base link region;
filling the second cavity (54) to form a completed base link region from the initial part (52) of the base link region and the filled second cavity (64);
forming an emitter (70) in the emitter window; and wherein the second oxide layer (2, 22) has a faster etch rate than the first oxide layer (4, 24), to allow preferential removal of the second oxide layer (2, 22) relative to the first oxide layer (4, 24) during formation of the first cavity (42).

2. The method of claim 1, comprising, prior to depositing the extrinsic base layer (30), patterning the first and second oxide layers to form an island comprising a remaining part of the first oxide layer (24) and a remaining part of the second oxide layer (22).

3. The method of claim 2, wherein depositing the extrinsic base layer (30) comprises depositing the extrinsic base layer on the island and parts of the major surface that surround a periphery of the island.

4. The method of claim 2 or claim 3, wherein forming the emitter window (36) exposes a central region of the island.

5. The method of any of claims 2 to 4, wherein removing at least a part of the second oxide layer (2, 22) comprises removing the remaining part (22) of the second oxide layer, and wherein removing at least a part of the first oxide layer (4, 24) comprises removing the remaining part of the first oxide layer (24).

6. The method of any of claims 2 to 5, wherein the faster etch rate of the second oxide layer (2, 22) causes the remaining part of the second oxide layer (22) to have a smaller footprint than the remaining part of the first oxide layer (24).

7. The method of any preceding claim, wherein forming the initial part (52) of a base link region in the first cavity comprises a Si and/or SiGe growth step.

8. The method of any preceding claim, further comprising forming an emitter spacer (38) in the emitter window (36) after forming the completed base link region and prior to forming the emitter (70) in the emitter window (36).

9. The method of any preceding claim, comprising using a hydrogen sealing process to fill the second cavity.

10. The method of any of claims 1 to 8, comprising using a selective epitaxial growth step to fill the second cavity (54).

11. The method of any preceding claim, wherein the first oxide layer (4, 24) is thinner than the second oxide layer (2,22).

## Patentansprüche

1. Verfahren zum Herstellen eines Bipolartransistors (10), wobei das Verfahren umfasst:
Bereitstellen eines Halbleitersubstrats (16), umfassend:
eine Hauptoberfläche;
eine oder mehrere Schichten (8, 12, 14), die sich unterhalb der Hauptoberfläche befinden, um eine intrinsische Basis des Bipolartransistors zu bilden; und einen Kollektor (18), der sich unter der einen oder den mehreren Schichten befindet;
Abscheiden einer ersten Oxidschicht (4, 24) auf der Hauptoberfläche;
Abscheiden einer zweiten Oxidschicht (2, 22) auf der ersten Oxidschicht (4);
Abscheiden einer extrinsischen Basisschicht (30) auf der zweiten Oxidschicht (22);
Bilden eines Emitterfensters (36) durch die extrinsische Basisschicht (30) hindurch;
Entfernen mindestens eines Teils der zweiten Oxidschicht (22), um einen ersten Hohlraum (42) zwischen der ersten Oxidschicht (24) und der extrinsischen Basisschicht (30) zu bilden;
Bilden eines Anfangsteils (52) eines Basisverbindungsgebiets in dem ersten Hohlraum (42);
Entfernen mindestens eines Teils der ersten Oxidschicht (24), um einen zweiten Hohlraum (54) zwischen der Hauptoberfläche und dem Anfangsteil (52) des Basisverbindungsgebiets zu bilden;
Füllen des zweiten Hohlraums (54), um ein fertiggestelltes Basisverbindungsgebiet aus dem Anfangsteil (52) des Basisverbindungsgebiets und dem gefüllten zweiten Hohlraum (64) zu bilden;
Bilden eines Emitters (70) in dem Emitterfenster; und wobei die zweite Oxidschicht (2, 22) eine schnellere Ätzrate als die erste Oxidschicht (4, 24) aufweist, um bevorzugte Entfernung der zweiten Oxidschicht (2, 22) relativ zu der ersten Oxidschicht (4, 24) während der Bildung des ersten Hohlraums (42) zu ermöglichen.

2. Verfahren nach Anspruch 1, umfassend Strukturieren der ersten und zweiten Oxidschicht vor Abscheiden der extrinsischen Basisschicht (30), um eine Insel zu bilden, die einen verbleibenden Teil der ersten Oxidschicht (24) und einen verbleibenden Teil der zweiten Oxidschicht (22) umfasst.

3. Verfahren nach Anspruch 2, wobei Abscheiden der extrinsischen Basisschicht (30) Abscheiden der extrinsischen Basisschicht auf der Insel und Teilen der Hauptoberfläche, die eine Peripherie der Insel umgeben, umfasst.

4. Verfahren nach Anspruch 2 oder Anspruch 3, wobei Bilden des Emitterfensters (36) ein zentrales Gebiet der Insel freilegt.

5. Verfahren nach einem der Ansprüche 2 bis 4, wobei Entfernen mindestens eines Teils der zweiten Oxidschicht (2, 22) Entfernen des verbleibenden Teils (22) der zweiten Oxidschicht umfasst, und wobei Entfernen mindestens eines Teils der ersten Oxidschicht (4, 24) Entfernen des verbleibenden Teils der ersten Oxidschicht (24) umfasst.

6. Verfahren nach einem der Ansprüche 2 bis 5, wobei die schnellere Ätzrate der zweiten Oxidschicht (2, 22) bewirkt, dass der verbleibende Teil der zweiten Oxidschicht (22) eine kleinere Grundfläche als der verbleibende Teil der ersten Oxidschicht (24) aufweist.

7. Verfahren nach einem der vorhergehenden Ansprüche, wobei Bilden des Anfangsteils (52) eines Basisverbindungsgebiets in dem ersten Hohlraum einen Si- und/oder SiGe-Wachstumsschritt umfasst.

8. Verfahren nach einem der vorhergehenden Ansprüche, ferner umfassend Bilden eines Emitterabstandhalterss (38) in dem Emitterfenster (36) nach dem Bilden des fertiggestellten Basisverbindungsgebiets und vor dem Bilden des Emitters (70) in dem Emitterfenster (36).

9. Verfahren nach einem der vorhergehenden Ansprüche, umfassend Verwenden eines Wasserstoffversiegelungsprozesses zum Füllen des zweiten Hohlraums.

10. Verfahren nach einem der Ansprüche 1 bis 8, umfassend Verwenden eines selektiven epitaktischen Wachstumsschritts zum Füllen des zweiten Hohlraums (54).

11. Verfahren nach einem der vorhergehenden Ansprüche, wobei die erste Oxidschicht (4, 24) dünner als die zweite Oxidschicht (2, 22) ist.

## Revendications

1. Procédé de fabrication d'un transistor bipolaire (10), le procédé comprenant :
l'obtention d'un substrat semi-conducteur (16) comprenant :
une surface principale ;
une ou plusieurs couches (8, 12, 14) situées sous la surface principale pour former une base intrinsèque du transistor bipolaire ; et
un collecteur (18) situé sous la ou les couches ;
le dépôt d'une première couche d'oxyde (4, 24) sur la surface principale ;
le dépôt d'une deuxième couche d'oxyde (2, 22) sur la première couche d'oxyde (4) ;
le dépôt d'une couche de base extrinsèque (30) sur la deuxième couche d'oxyde (22) ;
la formation d'une fenêtre d'émetteur (36) à travers la couche de base extrinsèque (30) ;
le retrait d'au moins une partie de la deuxième couche d'oxyde (22) pour former une première cavité (42) entre la première couche d'oxyde (24) et la couche de base extrinsèque (30) ;
la formation d'une partie initiale (52) d'une région de liaison de base dans la première cavité (42) ;
le retrait d'au moins une partie de la première couche d'oxyde (24) pour former une deuxième cavité (54) entre la surface principale et la partie initiale (52) de la région de liaison de base ;
le remplissage de la deuxième cavité (54) pour former une région de liaison de base finie à partir de la partie initiale (52) de la région de liaison de base et de la deuxième cavité remplie (64) ;
la formation d'un émetteur (70) dans la fenêtre d'émetteur ; et dans lequel la deuxième couche d'oxyde (2, 22) présente une vitesse de gravure plus rapide que la première couche d'oxyde (4, 24), pour permettre un retrait préférentiel de la deuxième couche d'oxyde (2, 22) par rapport à la première couche d'oxyde (4, 24) pendant la formation de la première cavité (42).

2. Procédé de la revendication 1 comprenant, avant le dépôt de la couche de base extrinsèque (30), le modelage des première et deuxième couches d'oxyde pour former un îlot comprenant une partie restante de la première couche d'oxyde (24) et une partie restante de la deuxième couche d'oxyde (22).

3. Procédé de la revendication 2, dans lequel le dépôt de la couche de base extrinsèque (30) comprend le dépôt de la couche de base extrinsèque sur l'îlot et des parties de la surface principale qui entourent une périphérie de l'îlot.

4. Procédé de la revendication 2 ou la revendication 3, dans lequel la formation de la fenêtre d'émetteur (36) expose une région centrale de l'îlot.

5. Procédé de l'une quelconque des revendications 2 à 4, dans lequel le retrait d'au moins une partie de la deuxième couche d'oxyde (2, 22) comprend le retrait de la partie restante (22) de la deuxième couche d'oxyde, et dans lequel le retrait d'au moins une partie de la première couche d'oxyde (4, 24) comprend le retrait de la partie restante de la première couche d'oxyde (24).

6. Procédé de l'une quelconque des revendications 2 à 5, dans lequel la vitesse de gravure plus rapide de la deuxième couche d'oxyde (2, 22) se solde par le fait que la partie restante de la deuxième couche d'oxyde (22) présente une plus petite empreinte que la partie restante de la première couche d'oxyde (24).

7. Procédé d'une quelconque revendication précédente, dans lequel la formation de la partie initiale (52) d'une région de liaison de base dans la première cavité comprend une étape de croissance de Si et/ou de SiGe.

8. Procédé d'une quelconque revendication précédente, comprenant en outre la formation d'une entretoise d'émetteur (38) dans la fenêtre d'émetteur (36) après la formation de la région de liaison de base finie et avant la formation de l'émetteur (70) dans la fenêtre d'émetteur (36).

9. Procédé d'une quelconque revendication précédente, comprenant l'utilisation d'un procédé de scellement sous hydrogène pour remplir la deuxième cavité.

10. Procédé de l'une quelconque des revendications 1 à 8, comprenant l'utilisation d'une étape de croissance épitaxiale sélective pour remplir la deuxième cavité (54).

11. Procédé d'une quelconque revendication précédente, dans lequel la première couche d'oxyde (4, 24) est plus mince que la deuxième couche d'oxyde (2,22).
